# EUROPEAN PATENT SPECIFICATION

(11) **EP 0 469 957 B1**
(45) Date of publication and mention of the grant of the patent: **18.12.1996**
(21) Application number: 91402029.2
(22) Date of filing: 22.07.1991
(51) Int. Cl.: G03F 7/105, G03F 7/038, G03F 7/039, G01N 21/64

(54) **Resin composition for image formation**
Harzzusammensetzung zur Bildherstellung
Composition de résine pour la formation d'une image

(30) Priority: 25.07.1990 JP 196508/90
(43) Date of publication of application: 05.02.1992
(73) Proprietor: MITSUBISHI RAYON CO., LTD., Tokyo 104 (JP)
(72) Inventor: Kushi, Kenji, c/o CENTRAL RESEARCH LAB., Otake-shi, Hiroshima-ken (JP); Inukai, Ken-ichi, c/o CENTRAL RESEARCH LAB., Otake-shi, Hiroshima-ken (JP); Iseki, Takayuki, c/o CENTRAL RESEARCH LAB., Otake-shi, Hiroshima-ken (JP); Koyanagi, Seiya, c/o CENTRAL RESEARCH LAB., Otake-shi, Hiroshima-ken (JP); Fujimoto, Yasuyuki, c/o CENTRAL RESEARCH LAB., Otake-shi, Hiroshima-ken (JP)
(74) Representative: Fort, Jacques

(56) References cited:
- DE-A- 2 004 262
- DERWENT ACCESSION no. 89-275 170, Questel Tele- systems (WPIL) DERWENT PUBLICATIONS LTD., London
- DERWENT ACCESSION no. 86-187 125, Questel Tele- systems (WPIL) DERWENT PUBLICATIONS LTD., London

## Description

The present invention relates to a fluorescent resin-composition for image formation and a method for automatic optical inspection method by a fluorescence detecting system.

In the manufacturing-process of printed circuit-boards, optical inspection are important not only for identifying existing defects of printed circuit-boards, but also for supervising changes of conditions of the production-process, discovering the main causes of the defects and striving for improvement of yield and quality.

This optical inspection was once entirely based on visual inspection, but because of problems concerning accuracy of such inspection and personnel expenses, machines for automatic optical inspection become widespread.

However, usual machines for automatic optical inspection were based on the principle of recognizing the image by detecting the strength of the light reflected by the substrate. So, this method can be applied to inspect of a metal pattern image formed on the insulating layer obtained by etching a copper clad board, as the reflection from the metal's surface is strong and the reflection from the insulating layer is weak.

But in case of a board before etching which has a resin composition for image formation on the metal's surface, or a board with a solder resist resin layer formed on the metal's surface, the reflection of the surface of the resin becomes very strong and therefore cannot be distinguished from the light reflected by the metal's surface and therefore optical inspection is impossible.

For solving this problem, a new method for automatic optical inspection using fluorescence excited by laser-light, has been developed. In this method, the substrate is illuminated by laser-light of a specific wavelength (in the range of 400 - 650 nm) and fluorescence light is detected and pattern recognition is carried out. Lasers used for excited fluorescence are visible laser-light such as Ar-laser (488, 515 nm), and He-Cd-laser (442 nm) which can be obtained as a strong light with a relatively cheap equipment.

For example, VISION-206, a machine for automatic optical inspection, produced by Optrotek, uses a wavelength of 442 nm for the illuminating light and carries out the detection of the fluorescent light in the range of 490-620 nm. According to this method, because of the fact that organic material and metal parts can be distinguished without taking into account the different roughness of the surface, there is not only the possibility of checking the substrate after etching process but also before etching and after solder-resist formation. When, for example, an etching resist layer with a predetermined image is formed on a copper clad board, lack of resist due to a deficiency of the laminate or exposure process can be detected.

The realization of automatic optical inspection of formatted images by organic etching resist or plating resist on copper clad boards, gives a remarkable advantage concerning costs, because it provides the possibility of discovering defects in an early stage; when failures occur the organic resists are removed and the copper clad board can be used again.

But because the intensity of the fluorescence caused by illumination of light at 400 to 650 nm is very low for prior art resins used for image formation, excessive amplification of the signal is needed to detect image and image faults. Because of this excessive amplification the slightest impurities on the surface, adhering dust or slight residue of resist resin on developed area are also detected as image defects. Wrong information occurs easily and checking is difficult. Especially when images are fine, wrong information occurs very often and optical inspection becomes impossible. Then the merits of automatic appearance check by fluorescence detecting method cannot serve anymore.

### Summary of the Invention

It is an object of the present invention to solve the above mentioned problems and to provide a resin composition for image formation which emits sufficient intensity of fluorescence to be checked by equipment of automatic optical inspection which detects fluorescence, and to provide a method based on automatic optical inspection using the resin composition.

As a result of earnest examination in order to achieve the above mentioned objective, the inventors of the present invention found out how the objective can be accomplished by using a resin composition for image formation, described as follows, and got to the completion of the present invention.

The present invention relates to a resin composition for image formation according to claim 1.

The present invention further relates to a method of automatic optical inspection using the composition, according to claim 6.

A sufficient fluorescence intensity is obtained by exciting with light of the wavelength in the range of 400 nm to 650 nm; a check by equipment for automatic optical inspection using fluorescence detection method is possible and specially an increase in quality and yield of the printed circuit boards and the production process as well as a decrease of production costs can be obtained.

### Detailed Description of the Preferred Embodiments

Below, the present invention is explained in detail.

The evaluation-method of the fluorescence intensity of the present invention involves the steps of:
spreading the resin composition for image formation on the metal board beyond the scope of the visual field of the fluorescence microscope,
forming the plane image, which has a thickness of 50 micrometers, by drying or hardening,
using a Nikon OPTIPHOTO XF-EFD2 fluorescence microscope (a product of Nippon Kogaku KK), (excitation filter: EX-435/10, dichroic mirror: DM-455, absorption filter: BA-480, objective lens: PLAN 4/0.13, projection lens: CFPL5X, ND2 filter: open, ND4 filter: open, lever of vision field: open, shutter: open) and a Nikon AFX-II (ASA-100, exposure correction 0), which is an apparatus for taking photographs on the microscope, and taking a photograph of plane image by the reflection method.

The evaluation is done in relation with the exposure time. The device can measure the exposure time by means of a shutter which is automatically released when a quantity of light which exceeds a predetermined value is received.

According to the evaluation method it is necessary that the resin composition for image formation has a exposure time not more than 8 seconds, preferably not more than 6 seconds. When the inspection is performed with automatic optical inspection equipment by means of fluorescence detecting method and the exposure time for the used resin composition for image formation exceeds 8 seconds, incorrect information is easily obtained and brings about impediments in the inspection. Especially when pattern images are very fine, false information is obtained extremely often and optical inspection becomes impossible.

As for the present invention, the fluorescent substances contained in the resin composition used for image formation emit fluorescence with a wavelength not more than 800 nm when excited with light of the wavelength in the range of 400 to 650 nm. Besides this, it is advantageous when these substances are uniformly dissolved or dispersed in the resin composition used for image formation of the present invention.
Examples of such a fluorescence emitting substance are:C.I. Disperse Yellow 82,
C.I. Solvent Yellow 104,
C.I. Solvent Yellow 116,
C.I. Solvent Yellow 44,
Product of Mitsui Toatsu Dyes Ltd. EG-302
Product of Mitsui Toatsu Dyes Ltd. EG-307
or 4,4′-bis(alkylamino)benzophenon and other compounds can be listed. These can be used alone form or in a mixture.

Considering the cost, easy availability, emission of strong fluorescence and little effect to resin curing speed and shape of cross section of the image profile,
C.I. Disperse Yellow 82,
C.I. Solvent Yellow 104,
C.I. Solvent Yellow 116,
C.I. Solvent Yellow 44,
are preferably chosen.

As described above, these fluorescence emitting substances have to be added to the composition so that the exposure time for the photograph of the dried or hardened state of the resin composition for image formation, taken by the fluorescence microscope, is not more than 8 seconds. The added quantity cannot be said sweepingly as it depends on the kind of compound.

Preferable quantity of above described preferred compounds are:
not less than 0.0005 weight % of C.I. Disperse Yellow 82
not less than 0.003 weight % of C.I. Solvent Yellow 104
not less than 0.001 weight % of C.I. Solvent Yellow 116
not less than 0.001 weight % of C.I. Solvent Yellow 44

When the thickness of the dried or hardened composition is thin, even if the exposure time is not more than 8 seconds when converted to 50 micrometer thickness, the added amount of the fluorescent compound is preferably increased.

Resin composition used in the present invention includes
resin which can be solidified by vaporization of organic solvent or water,
heat-curable resin (negative type photosensitive resin) and
positive type photosensitive resin, which is characterized in that only the part which is exposed to light becomes developable with adequate solvent.

Image formation process used in the present invention includes
offset printing process,
relief printing process and
screen printing process.

But, for formation of high resolution pattern image, it is preferable to use the so called photosensitive resin process, in which, pattern image is created by the step of
resin layer formation on the surface of substrate,
exposure with patterned light and
development.

As the photosensitive resin, it is preferable to use negative type photosensitive resin or positive type photosensitive resin.

As for the photo-curable resin, there is a resin composition containing compounds which have at least one polymerizable group.

For example of the photo-curable resin composition,
a resin composition containing a polymer having at least one polymerizable group on its main chain and/or side chain,
a resin composition containing monomers or oligomers which have polymerizable groups
and a mixture thereof can be mentioned.

As for examples of compounds having a polymerizable group in the main chain and/or side chain, there is an unsaturated polyester resin obtained from the condensation of polyhydric alcohol and unsaturated polybasic acid having a reactive double bond, such as a resin derived from
maleic anhydride / phthalic anhydride / propylene glycol,
maleic anhydride / isophthalic acid / propylene glycol,
maleic acid / fumaric acid / isophthalic acid / 1,3-butanediol,
maleic acid / isophthalic acid / neopentyl glycol,
maleic anhydride / tetrahydro phthalic anhydride / dipropylene glycol.

As monomers and oligomers with a polymerizable group, those having the a boiling point of more than 100 degrees Centigrade at atmospheric pressure and a molecule weight under 10000, are preferably used.

As for examples of such monomers and oligomers there are monofunctional (meth)acrylates and (meth)acrylamides such as
phenoxydiethoxy (meth)acrylate,
methoxy polyethylene glycol (meth)acrylate,
n-butoxymethyl (meth)acrylamide,
iso-butoxymethyl (meth)acrylamide;
poly (meth)acrylate of polyhydric alcohol such as
polyethylene glycol di(meth)acrylate,
polypropylene glycol di(meth)acrylate,
1,3-butanediol di(meth)acrylate,
1,6-hexanediol di(meth)acrylate,
neopentyl glycol di(meth)acrylate,
2,2-bis[4-(meth)acryloyloxy ethoxy ethoxy phenyl] propane,
2,2-bis[4-(meth)acryloyloxy propoxy propoxy phenyl] propane,
(meth)acryloyloxypivalyl (meth)acryloyloxypivalate,
glycerin di(meth)acrylate,
glycerin tri(meth)acrylate,
trimethylolethane di(meth)acrylate,
trimethylolethane tri(meth)acrylate,
trimethylolpropane di(meth)acrylate,
trimethylolpropane tri(meth) acrylate,
trimethylolpropane tris[ethoxy ethoxy (meth)acrylate],
trimethylolpropane tris[propoxy propoxy (meth)acrylate],
bis[(meth)acryloyloxyethyl] hydroxyethyl isocyanurate,
tris[(meth)acryloyloxyethyl] isocyanurate,
pentaerythritol di(meth)acrylate,
pentaerythritol tri(meth)acrylate,
pentaerythritol tetra(meth)acrylate,
di pentaerythritol tri(meth)acrylate,
di pentaerythritol tetra(meth)acrylate,
di pentaerythritol penta(meth)acrylate,
di pentaerythritol hexa(meth)acrylate;
epoxy acrylate which is obtained from a compound having a glycidil group and (meth)acrylic acid;
each of urethane (meth)acrylates stated in
Japanese patent publication number (Tokko Sho) 48 - 41708,
Japanese patent publication number (Tokko Sho) 50 - 6034 and
Japanese patent application laid-open number (Tokkai Sho) 51 - 37193;
each of the kinds of polyester (meth)acrylates stated in
Japanese patent publication number (Tokko Sho) 42 - 30490,
Japanese patent application laid open number (Tokkai Sho) 48 - 64183;
Japanese patent publication number (Tokko Sho) 49 - 43191; and other multifunctional (meth)acrylates.
Furthermore, polymerizable monomers and olygomers as stated in Nihon Setchaku Kyokai Shi, (Japanese Adhesive Association Journal) Vol. 20, No.7, P. 300 - 308, can be used. Out of these one kind or a mixture can be used. The amount used is preferably not less than 10 weight % of resin composition of the present invention.

In the present invention, the resin composition for image formation is preferably to contain a polymerizable compound which has more than one polymerizable group per molecule. When this resin composition for image formation is hardened by actinic light, the resin composition for image formation is preferably to contain photopolymerization initiators. As for such photopolymerization initiators there are for example
benzoin and substituted benzoins such as
benzoin,
benzoin ethyl ether,
benzoin isopropyl ether;
benzyl ketals such as
benzyl dimethyl ketal;
substituted acetophenones such as
2,2-diethoxy acetophenone,
2-hydroxy-2-methyl-1-phenyl propane-1-one,
1-hydroxy cyclohexyl phenyl ketone,
p-tert-butyl trichloroacetophenone,
2-methyl-[4-(methyl thio)phenyl]-2-morpholino-1-propanone;
alpha-dicarbonyls such as
benzyl;
alpha-acyl oximes such as
1-phenyl-1,2-propanedione-2-(o-ethoxy carbonyl) oximes;
aromatic ketones such as
benzophenone,
o-benzoyl benzoic acid methyl ester;
thioxanthone and substituted thioxanthones such as
thioxanthone,
2,4-diethyl thioxanthone;
anthraquinone and substituted anthraquinones;
amine compounds such as
Michler's ketone,
p-dimethylamino benzoic acid ethyl ester;
trimethyl benzoyl diphenyl phosphine oxide;
and photopolymerization initiators which are photosensitive in the visible range, such those stated in "Kino Zairyo" (Functional Material) (1986, (10) pp.46-61)can be listed. They can be used alone or in a mixture.

These optical polymerization initiators are preferably not more than 10 weight percent of the resin composition for image formation according to the present invention. But when the activating ray is an electron beam, they don't have to be added.

The resin composition for image formation according to the present invention can include thermoplastic polymeric binder in order to grant or improve adhesion, developing, film formability and other various performances. As for thermoplastic polymeric binder,
copolymers such as
(meth)acrylate copolymers,
styrene-(meth)acrylate copolymer,
acrylonitril-(meth)acrylate copolymer,
polyvinylpyrolidone,
polyvinyl alcohol,
(meth)acrylate-(meth)acrylic acid copolymer,
styrene-(meth)acrylic acid copolymer,
styrene-maleic acid copolymer,
(meth)acrylate-(meth)acrylamide copolymer
can be used, and as long as there is compatibility with the other components every thermoplastic polymeric binder can be used. One kind of these polymers may be used alone, but also an adequate proportioned mixture of two or more.

In case of an alkali developable negative type photosensitive resin composition, as copolymer component it preferably contains monomers having an alpha, beta-unsaturated carboxyl group of 3 to 15 carbon atoms and more preferably contains acrylic acid or methacrylic acid. The resin composition for image formation according to the present invention may contain an optional amount of the thermoplastic polymeric binder. But when the containing amount exceeds 90 weight percent, the mechanical strength of the formatting hard body becomes weak, which is not desirable.

As the need arises, it is possible to add components such as several kinds of resins , hardening promotor, adhesion promotor, thermal polymerization inhibitor, dyestuff, pigment, plasticizer, thickener, antifoamer, flame retarder and filler to the resin composition for image formation according to the present invention.

Resin composition for image formation according to the present invention can be used in many different purposes, such as printing, photoresist, coating and others. But it is especially useful as image forming material used in the manufacturing process for printed circuit boards, in other words, as etching resist or plating resist, solder resist in circuit image formation or as ink for symbol printing. The resin composition for pattern recognition according to the present invention applied in such a way may be used in liquid form or in a semi solid state as dry film resist.

The resin composition for image formation according to the present invention can be put on the base material just as it is and form a film, but it can also be applied as a solution and dried thereafter. The preferable solvents for the solution include
acetone,
methylethylketone,
methylcellosolve,
ethylcellosolve,
dichloromethane,
chloroform,
methylalcohol,
ethylalcohol,
isopropylalcohol,
and others having a low boiling point.

Furthermore, the liquid resin composition for image formation is applied and dried on a polyethylene terephthalate support or others to form a dry film resist which can be laminated on the base material.

The preferred embodiments are concretely explained below.

### Example 1:

The components described below were mixed and kneaded by means of a triple roll apparatus and the liquid resin composition was obtained.

| | |
|---|---|
| TOHRAD^{TM} 3800 ( a product of Tohtokasei Co., Ltd., COOH modified bis phenol A Type epoxyacrylate) | 35 weight parts |
| Trimethylol propanetriacrylate | 35 weight parts |
| benzyl acrylate | 18 weight parts |
| benzyl dimethyl ketal | 4 weight parts |
| Aerozil^{TM} # 200 (a product of Nihon Aerozil, amorphous silica) | 8 weight parts |
| C.I. Solvent Yellow 116 (a prod. of Nippon Kayaku Co. Ltd, Kayaset^{TM} Flavine FG) | 0.05 weight parts |

This liquid resin composition is applied on the copper clad board to get a layer of 50 micrometer thick. After plate covering each of the coated copper clad boards with a 20 micrometer thick film of polyethylene terephthalate, two kinds of photo-tools, such as
1. whole transparent
2. line/space (L/S) = 200/200 micrometers
are put on top of them, exposed to the light of a high pressure mercury lamp and hardened. The light exposure is set to be 15 steps measured with 25 steps tablet (a product of Mitsubishi Reyon Co., Ltd.). After that the nonexposed parts were developed by spraying a 1% aqueous solution of sodium carbonate on it. The development was done for one minute at a solution temperature of 30 degrees Centigrade.
Reflection method yields a photograph which is taken of the plane image obtained by means of photo-tool 1 and measured, using a Nikon OPTIFOTO XF-EFD2 fluorescence microscope (excitation filter: EX-435/10, dichroic mirror: DM-455, absorption filter: BA-480, objective lens: PLAN 4/0.13, projection lens: CFPL5X, ND2 filter: open, ND4 filter: open, lever of vision field: open, shutter: open) and a Nikon AFX-II (ASA-100, exposure correction 0) which is an apparatus for taking photos on the microscope: The exposure time of this procedure was measured. The result is shown in table 2.

The image obtained by photo-tool 2 was subjected to an optical inspection by means of an automatic optical inspection equipment OPTROTEC VISION - 206 with various fluorescence amplification rates. The result in table 2 shows that the optical inspections were done at best condition.

### Examples 2 - 9:

Instead of C.I. Solvent Yellow 116 (0.05 weight parts) from Example 1, compounds and amounts as stated in table 1 were used in a process similar to that of Example 1, so that liquid resin compositions were obtained. Obtained liquid resin compositions were evaluated by a process similar to that of Example 1 and the results were listed in table 2.

### Comparative example 1:

Liquid resin compositions were obtained by a process similar to that of Example 1 without adding C.I. Solvent Yellow 116. Obtained liquid resin compositions were evaluated by a process similar to that of Example 1 and the result was listed in table 2.

**Table 1**

| Compounds and their amounts used for embodiments 2 to 9 | | | |
|---|---|---|---|
| Example | fluorescence emitting substance | | weight parts added amount |
| | Name of Color Index or compound | commodity name | |
| 2 | C.I. Solvent Yellow 116 | Nippon Kayaku Co., Ltd. Kayaset^{TM} Flavine FG | 0.1 |
| 3 | C.I. Solvent Yellow 104 | Mitsubishi Chem. Ind., Ltd. Diaresin^{TM} Yellow F | 0.1 |
| 4 | C.I. Disperse Yellow 82 | Nippon Kayaku Co., Ltd. Kayaset^{TM} Yellow SF-G | 0.1 |
| 5 | C.I. Solvent Yellow 44 | Nippon Kayaku Co., Ltd. Kayaset^{TM} Flavine FN | 0.1 |
| 6 | | Mitsui Toatsu Dyes Ltd., EG 302 | 0.005 |
| 7 | | Mitsui Toatsu Dyes Ltd., EG 307 | 0.005 |
| 8 | 4,4'-bis (dimethyamino)benzophenone | | 0.4 |
| 9 | 4,4'-bis (diethyamino) bezophenone | | 0.4 |

**Table 2**

| Example | exposure time (sec.) | optical inspection by VISION 206 |
|---|---|---|
| 1 | 0.6 | v |
| 2 | 0.4 | v |
| 3 | 2.0 | v |
| 4 | 0.3 | v |
| 5 | 0.6 | v |
| 6 | 3.5 | v |
| 7 | 1.6 | v |
| 8 | 5.7 | v |
| 9 | 3.7 | v |
| comp. example 1 | 16.2 | x |
| v.......no wrong information, check is possible x.......too much wrong information, no check is possible | | |

### Example 10:

The components described below are put together and a mixture of liquid resin composition is obtained.

A solution of methyl methacrylate/ methyl acrylate/ methacrylic acid (55/ 20/ 25 weight ratio) copolymer ( average molecular weight 90,000) dissolved in isopropylalcohol/ methyl ethyl keton (50/ 50 weight ratio)
150 weight parts (58 weight parts as solid)

| | |
|---|---|
| trimethylolpropane triacrylate | 15 weight parts |
| tetraethylene glycol diacrylate | 20 weight parts |
| benzyldimethylketal | 6.9 weight parts |
| Malachite Green | 0.1 weight parts |
| C.I. Solvent Yellow 116 | 0.005 weight parts |

This liquid resin composition was put on a 25 micrometer thick polyethylene terephthalate film and dried and a dry film resist , photosensitive layer thereof having thickness of 50 micrometer was obtained. Then the obtained coating layer of the dry film resist is laminated on the copper clad board. And the following three kinds of photo-tools are put on each of boards on its top.
1. whole transparent
2. line/ space (L/S) = 200/ 200 micrometer
3. line/ space (L/S) = 100/ 100 micrometer
and then they are exposed to the light of a high pressure mercury lamp and hardened. For exposure a mercury vapor lamp USH - 102 D (a prod. of Ushio Inc.) is used and the light exposure is set to be 15th steps measured by the 25 steps tablet ( a prod. of Mitsubishi Rayon Co., Ltd.). The exposure energy for 15th steps therefore are listed in table 5. Then the polyethylene terephtharate film was peeled off and the nonexposed parts were developed by spraying a 1% aqueous solution of sodium carbonate. The development was done for one minute at a liquid temperature of 30 degrees Centigrade.

The image obtained by using photo-tool 1 is similarly evaluated as embodiment 1 by measuring the exposure time. Results are listed in table 5. Furthermore, the image obtained by using photo-tools 2 and 3 is similarly carried out as embodiment 1 by optical inspection using VISION - 206. Results are listed in table 5.

Then the image obtained by photo-tool 2 was cut by means of MICROTOME equipment and the image's cross-section was obtained. The shape of the cross-section of the lines having a width of 200 micrometers was observed. Result are also listed in table 5.

### Examples 11 - 14, comparative example 2:

Instead of C.I. Solvent Yellow 116 (0.005 weight parts) from Example 10, compounds and amounts as stated in table 3 were used and dry film resists were manufactured by a process similar to that of Example 10 and evaluated. Results are listed in table 5.

### Examples 15 - 31, comparative examples 3 - 7:

Instead of the photopolymerization initiator benzyldimethyl ketal (6.9 weight parts) from Example 10, 6.8 weight parts of benzophenon and 0.1 weight parts of N,N'-bis(dimethyamino)benzophenone are used together, and instead of C.I. Solvent Yellow 116 (0.005 weight parts), compounds and amounts as stated in table 4 were used and dry film resists were manufactured by a process similar to Example 10 and evaluated. Results are listed in table 5.

### Example 32:

Instead of the photopolymerization initiator benzyldimethyl ketal (6.9 weight parts) from Example 10, 6.8 weight parts of benzophenone and 0.25 weight parts of N,N'-bis (dimethyamino)benzophenone are used together, and C.I. Solvent Yellow 116 was not used. Dry film resists were manufactured by a process similar to Example 10 and evaluated. Results are listed in table 5.

**Table 3**

| | Fluorescence emitting substance | | weight parts of added amount |
|---|---|---|---|
| Example | Name of Color Index or compound | commodity name | |
| 10 | C.I. Solvent Yellow 116 | Nippon Kayaku Co., Ltd. Kayaset^{TM} Flavine FG | 0.005 |
| 11 | C.I. Solvent Yellow 116 | Nippon Kayaku Co., Ltd. Kayaset^{TM} Flavine FG | 0.002 |
| 12 | | Mitsui Toatsu Dyes Ltd., EG 302 | 0.004 |
| 13 | | Mitsui Toatsu Dyes Ltd., EG 302 | 0.0015 |
| 14 | N,N'-bis (dimethyamino)benzophenone | | 0.4 |
| comp. example 2 | | | 0 |

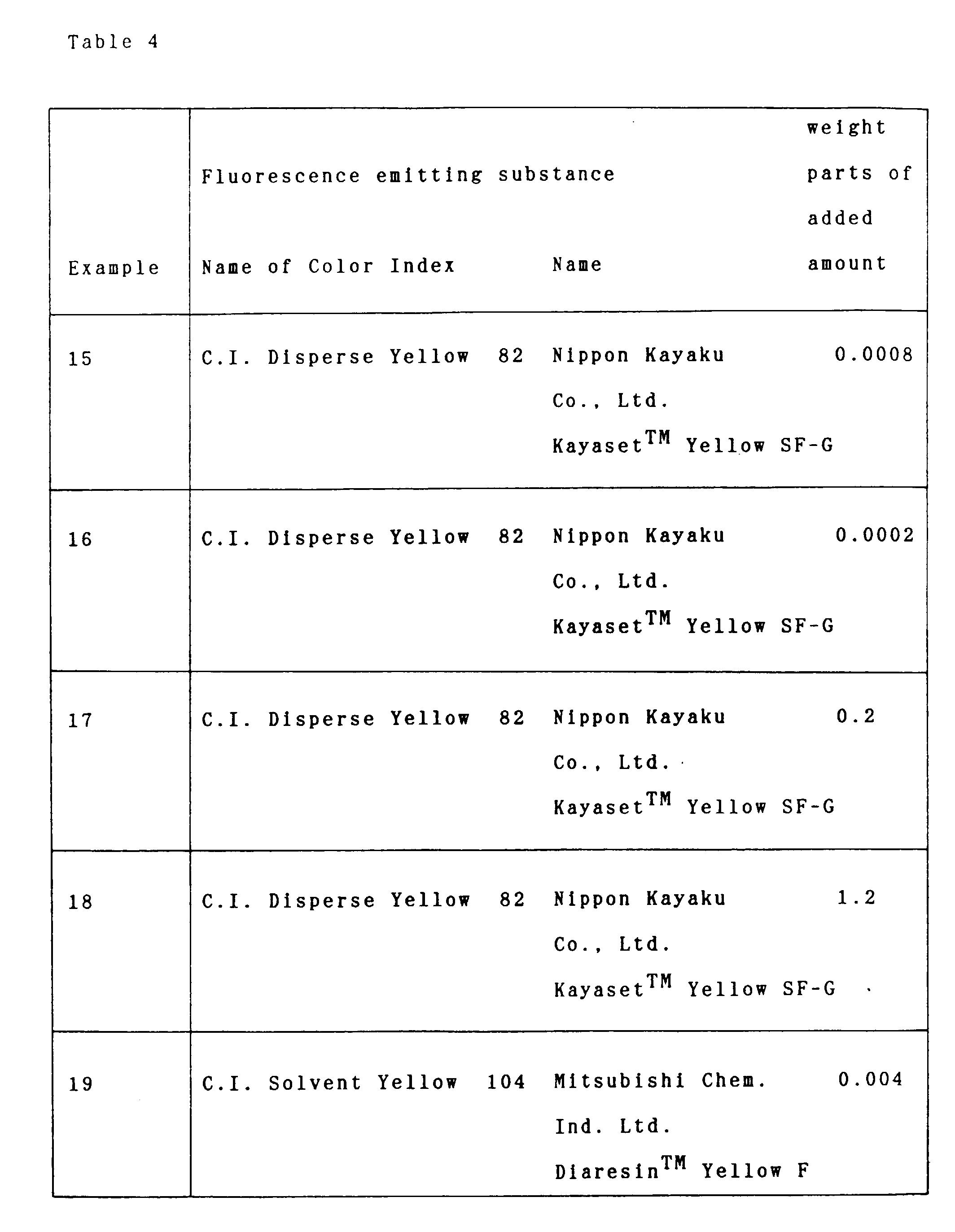

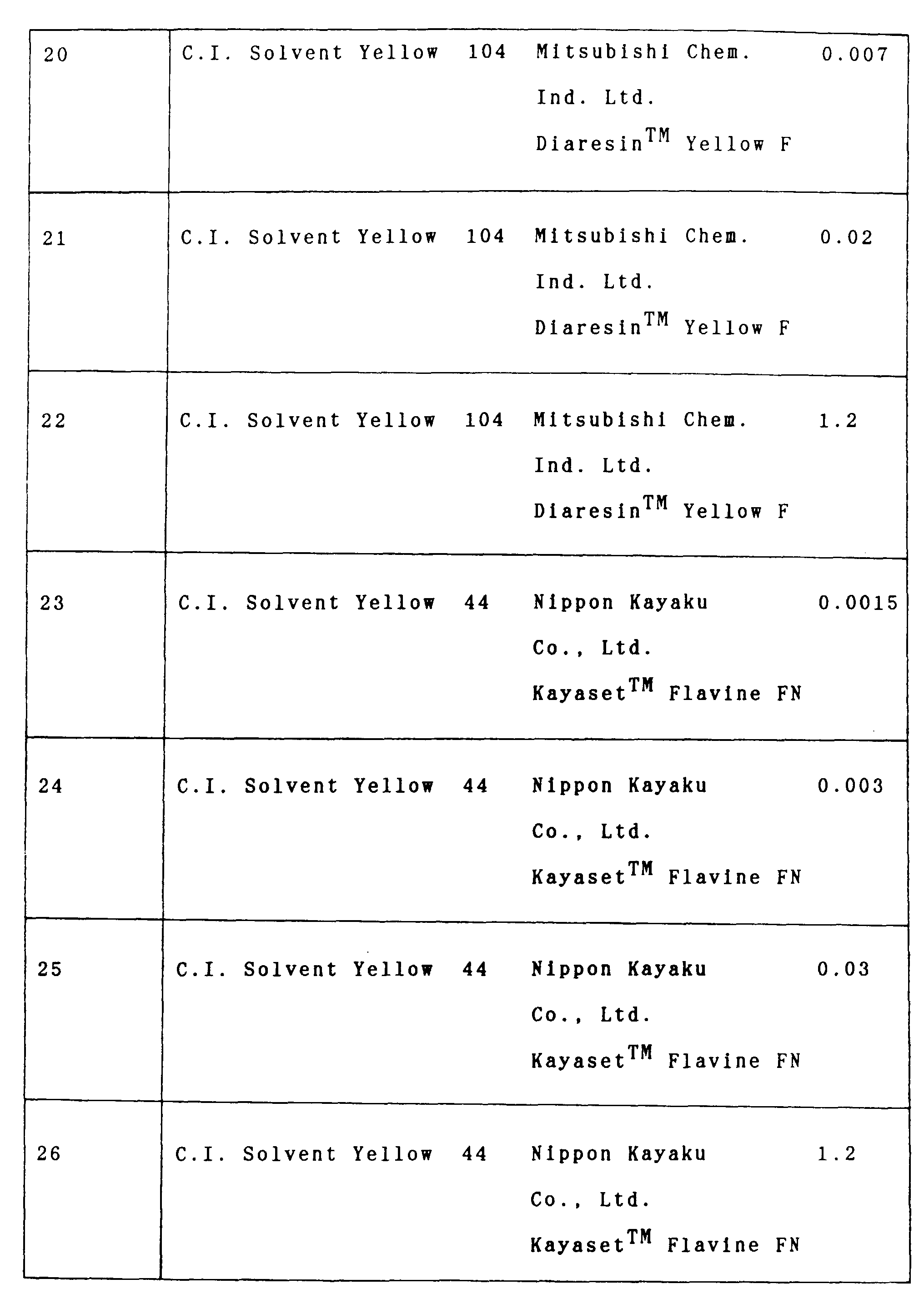

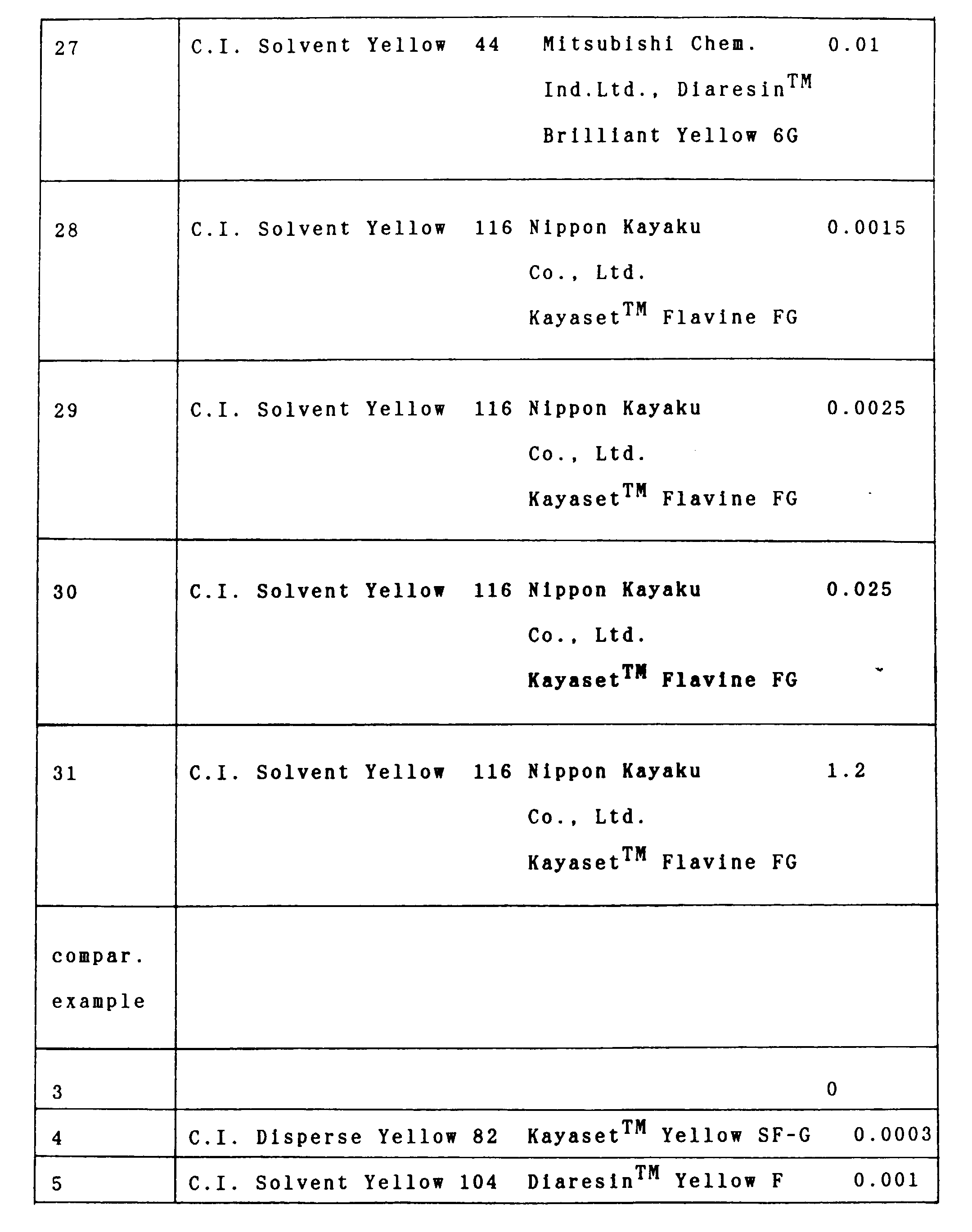

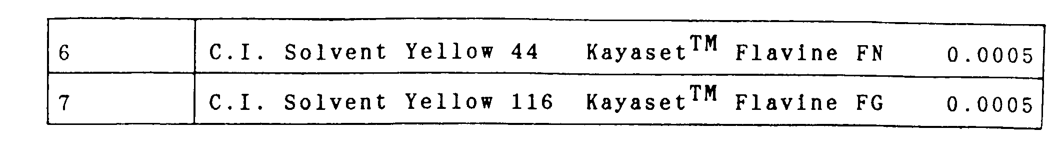

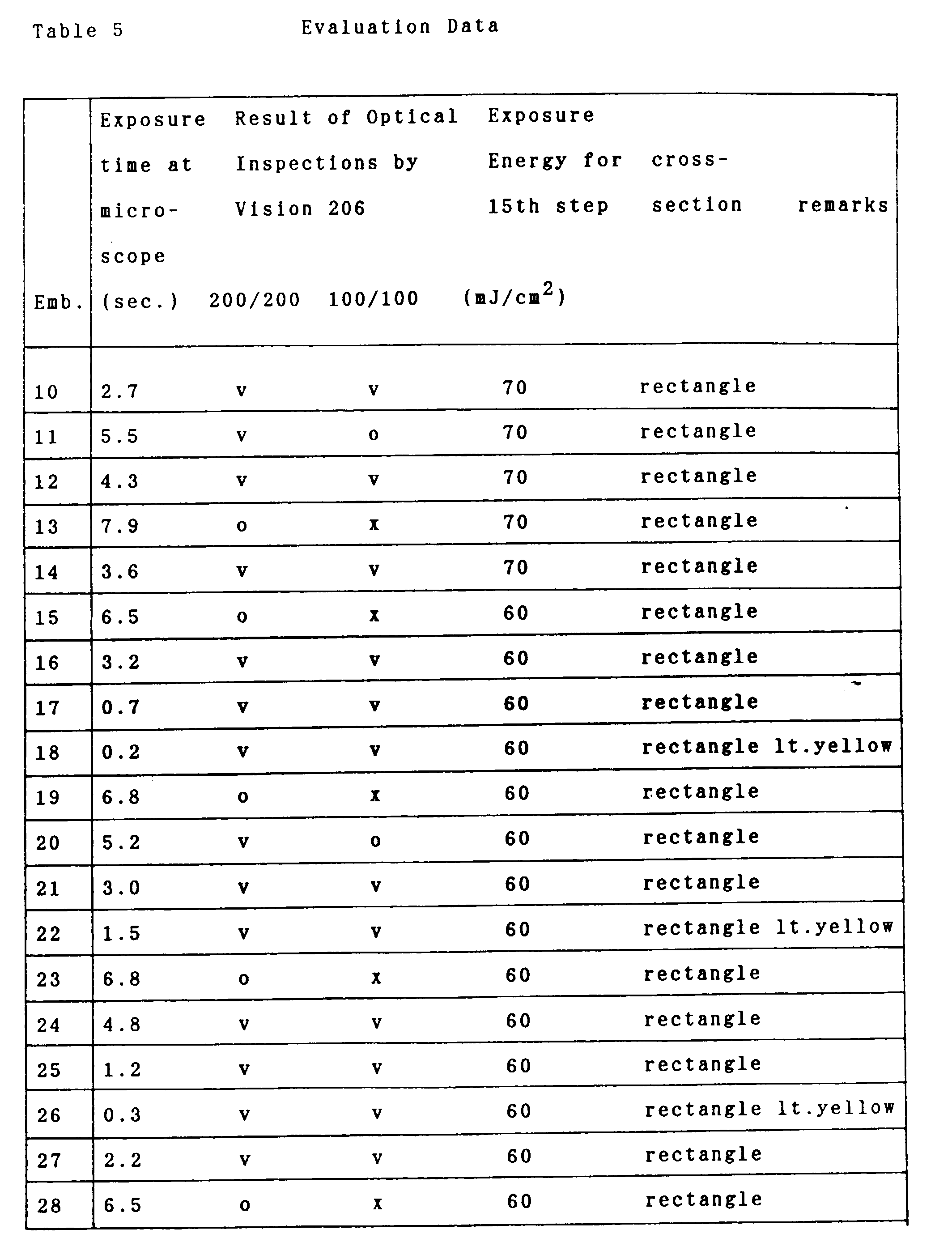

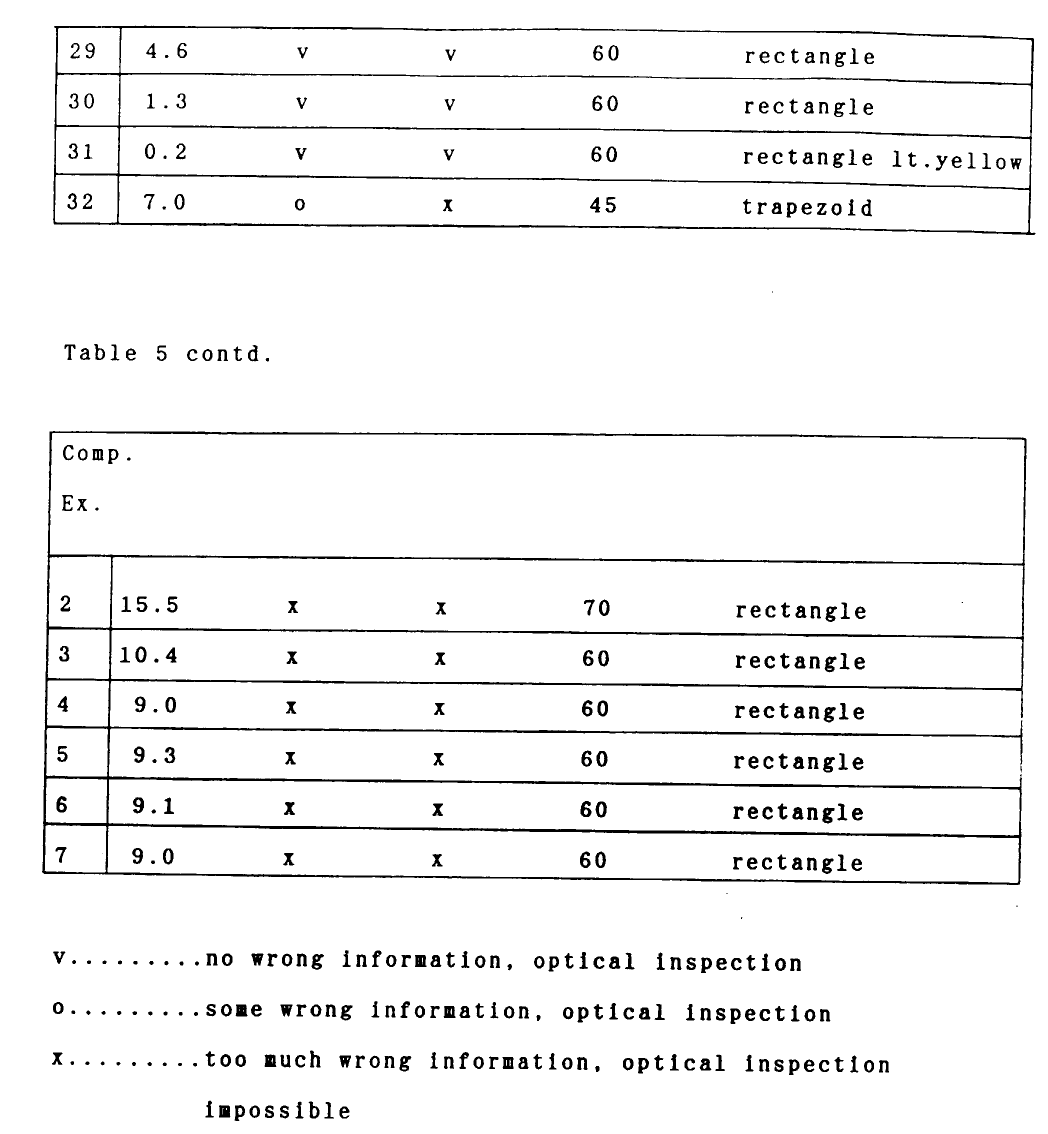

## Claims

1. A resin composition for image formation containing a compound which emits fluorescence at the exposure to light having a wavelength in the range of 400 to 650 nm, characterised in that said compound is selected from the group consisting of C.I. Disperse Yellow 82, C.I. Solvent Yellow 104, C.I. Solvent Yellow 116 and C.I. Solvent Yellow 44.

2. A resin composition for image formation according to claim 1, wherein said resin composition contains not less than 0.0005 weight percent of C.I. Disperse Yellow 82 as said compound which emits fluorescence.

3. A resin composition for image formation according to claim 1, wherein said resin composition contains not less than 0.003 weight percent of C.I. Solvent Yellow 104 as said compound which emits fluorescence.

4. A resin composition for image formation according to claim 1, wherein said resin composition contains not less than 0.001 weight percent of C.I. Solvent Yellow 116 as said compound which emits fluorescence.

5. A resin composition for image formation according to claim 1, wherein said resin composition contains not less than 0.001 weight percent of C.I. Solvent Yellow 44 as said compound which emits fluorescence.

6. A method for automatic optical inspection by means of fluorescence detection using a resin composition for image formation and a formed image, characterised in that said composition contains a compound which emits fluorescence at the exposure to light having a wavelength in the range of 400 to 650 nm which is selected from the group consisting of C.I. Disperse Yellow 82, C.I. Solvent Yellow 104, C.I. solvent Yellow 116 and C.I. Solvent Yellow 44.

7. A method for automatic optical inspection by means of fluorescence detection according to claim 6, wherein a resin composition for image formation containing not less than 0.0005 weight percent of C.I. disperse Yellow 82 is used as said compound which emits fluorescence.

8. A method for automatic optical inspection by means of fluorescence detection according to claim 6, wherein a resin composition for image formation containing not less than 0.003 weight percent of C.I. Solvent Yellow 104 is used as said compound which emits fluorescence.

9. A method for automatic optical inspection by means of fluorescence detection according to claim 6, wherein a resin composition for image formation containing not less than 0.001 weight percent of C.I. Solvent Yellow 116 is used as said compound which emits fluorescence.

10. A method for automatic optical inspection by means of fluorescence detection according to claim 6, wherein a resin composition for image formation containing not less than 0.001 weight percent of C.I. Solvent Yellow 44 is used as said compound which emits fluorescence.

## Patentansprüche

1. Harzzusammensetzung zur Bilderzeugung, enthaltend eine Verbindung, die bei Aussetzen an Licht mit einer Wellenlänge im Bereich von 400 bis 650 nm Fluoreszenzstrahlung emittiert, dadurch gekennzeichnet, daß die Verbindung ausgewählt ist aus der Gruppe bestehend aus C.I. Disperse Yellow 82, C.I. Solvent Yellow 104, C.I. Solvent Yellow 116 und C.I. Solvent Yellow 44.

2. Harzzusammensetzung zur Bilderzeugung nach Anspruch 1, wobei die Harzzusammensetzung nicht weniger als 0,0005 Gew.-% C.I. Disperse Yellow 82 als die Fluoreszenzstrahlung emittierende Verbindung enthält.

3. Harzzusammensetzung zur Bilderzeugung nach Anspruch 1, wobei die Harzzusammensetzung nicht weniger als 0,003 Gew.-% C.I. Solvent Yellow 104 als die Fluoreszenzstrahlung emittierende Verbindung enthält.

4. Harzzusammensetzung zur Bilderzeugung nach Anspruch 1, wobei die Harzzusammensetzung nicht weniger als 0,001 Gew.-% C.I. Solvent Yellow 116 als die Fluoreszenzstrahlung emittierende Verbindung enthält.

5. Harzzusammensetzung zur Bilderzeugung nach Anspruch 1, wobei die Harzzusammensetzung nicht weniger als 0,001 Gew.-% C.I. Solvent Yellow 44 als die Fluoreszenzstrahlung emittierende Verbindung enthält.

6. Verfahren zur automatischen optischen Inspektion mittels Erfassung von Fluoreszenzstrahlung unter Verwendung einer Harzzusammensetzung zur Bilderzeugung und eines erzeugten Bildes, dadurch gekennzeichnet, daß die Zusammensetzung eine Verbindung enthält, die bei Aussetzen an Licht mit einer Wellenlänge im Bereich von 400 bis 650 nm Fluoreszenzstrahlung emittiert, wobei die Verbindung ausgewählt ist aus der Gruppe bestehend aus C.I. Disperse Yellow 82, C.I. Solvent Yellow 104, C.I. Solvent Yellow 116 und C.I. Solvent Yellow 44.

7. Verfahren zur automatischen optischen Inspektion mittels Erfassung von Fluoreszenzstrahlung nach Anspruch 6, wobei eine Harzzusammensetzung zur Bilderzeugung, die nicht weniger als 0,0005 Gew.-% C.I. Disperse Yellow 44 enthält, als die Fluoreszenzstrahlung emittierende Verbindung verwendet wird.

8. Verfahren zur automatischen optischen Inspektion mittels Erfassung von Fluoreszenzstrahlung nach Anspruch 6, wobei eine Harzzusammensetzung zur Bilderzeugung, die nicht weniger als 0,0003 Gew.-% C.I. Solvent Yellow 104 enthält, als die Fluoreszenzstrahlung emittierende Verbindung verwendet wird.

9. Verfahren zur automatischen optischen Inspektion mittels Erfassung von Fluoreszenzstrahlung nach Anspruch 6, wobei eine Harzzusammensetzung zur Bilderzeugung, die nicht weniger als 0,001 Gew.-% C.I. Solvent Yellow 116 enthält, als die Fluoreszenzstrahlung emittierende Verbindung verwendet wird.

10. Verfahren zur automatischen optischen Inspektion mittels Erfassung von Fluoreszenzstrahlung nach Anspruch 6, wobei eine Harzzusammensetzung zur Bilderzeugung, die nicht weniger als 0,001 Gew.-% C.I. Solvent Yellow 44 enthält, als die Fluoreszenzstrahlung emittierende Verbindung verwendet wird.

## Revendications

1. Composition de résine pour la formation d'une image contenant un composé qui émet une fluorescence à l'exposition à la lumière ayant une longueur d'onde dans la plage de 400 à 650 nm, caractérisée en ce que le composé est choisi parmi le groupe consistant en C.I. Disperse Yellow 82, C.I. Solvent Yellow 104, C.I. Solvent Yellow 116 et C.I. Solvent Yellow 44.

2. Composition de résine pour la formation d'une image selon la revendication 1, dans laquelle la composition de résine ne contient pas moins de 0,0005 % en poids de C.I. Disperse Yellow 82 en qualité de composé qui émet la fluorescence.

3. Composition de résine pour la formation d'une image selon la revendication 1, dans laquelle la composition de résine ne contient pas moins de 0,003 % en poids de C.I. Solvent Yellow 104 en qualité de composé qui émet la fluorescence.

4. Composition de résine pour la formation d'une image selon la revendication 1, dans laquelle la composition de résine ne contient pas moins de 0,001 % en poids de C.I. Solvent Yellow 116 en qualité de composé qui émet la fluorescence.

5. Composition de résine pour la formation d'une image selon la revendication 1, dans laquelle la composition de résine ne contient pas moins de 0,001 % en poids de C.I. Solvent Yellow 44 en qualité de composé qui émet la fluorescence.

6. Procédé pour l'inspection optique automatique au moyen de la détection par fluorescence en utilisant une composition de résine pour la formation d'image et une image formée, caractérisé en ce que la composition contient un composé qui émet la fluorescence à l'exposition à la lumière d'une longueur d'onde dans la plage de 400 à 650 nm, qui est choisi parmi le groupe consistant en C.I. Disperse Yellow 82, C.I. Solvent Yellow 104, C.I. Solvent Yellow 116 et C.I. Solvent Yellow 44.

7. Procédé pour l'inspection optique automatique au moyen de la détection par fluorescence selon la revendication 6, dans lequel on utilise une composition de résine pour la formation d'image ne contenant pas moins de 0,0005 % en poids de C.I. Disperse Yellow 82 en qualité de composé qui émet la fluorescence.

8. Procédé pour l'inspection optique automatique au moyen de la détection par fluorescence selon la revendication 6, dans lequel on utilise une composition de résine pour la formation d'image ne contenant pas moins de 0,003 % en poids de C.I. Solvent Yellow 104 en qualité de composé qui émet la fluorescence.

9. Procédé pour l'inspection optique automatique au moyen de la détection par fluorescence selon la revendication 6, dans lequel on utilise une composition de résine pour la formation d'image ne contenant pas moins de 0,001 % en poids de C.I. Solvent Yellow 116 en qualité de composé qui émet la fluorescence.

10. Procédé pour l'inspection optique automatique au moyen de la détection par fluorescence selon la revendication 6, dans lequel on utilise une composition de résine pour la formation d'image ne contenant pas moins de 0,001 % en poids de C.I. Solvent Yellow 44 en qualité de composé qui émet la fluorescence.
